# EUROPEAN PATENT APPLICATION

(11) **EP 3 096 011 A1**
(43) Date of publication of application: **23.11.2016**
(21) Application number: 16168889.0
(22) Date of filing: 10.05.2016
(51) Int. Cl.: F04B 23/02, H01L 23/473, F04B 11/00

(54) **LIQUID SUPPLY DEVICE AND LIQUID COOLING SYSTEM**

(30) Priority: 12.05.2015 CN 201520303586 U; 22.05.2015 CN 201510266823
(71) Applicant: Cooler Master Co., Ltd., New Taipei City 235 (TW)
(72) Inventor: Chen, Hsin-Hung, 235 New Taipei City (TW); Liao, Pen-Hung, 235 New Taipei City (TW); Huang, Shih-Wei, 235 New Taipei City (TW)
(74) Representative: Becker Kurig Straus

(57) **Abstract**

A liquid supply device (20, 20', 30, 40) includes a casing (200, 300), a cover (202, 302), a plunger (204, 304) and a driving unit (205, 305, 405). The casing (200, 300) has a liquid outlet (2000, 3000). The cover (202, 302) is connected to the casing (200, 300). A chamber (208, 308) is formed between the casing (200, 300) and the cover (202, 302). The chamber (208, 308) communicates with the liquid outlet (2000, 3000). The plunger (204, 304) is movably disposed in the chamber (208, 308). The driving unit (205, 305, 405) is disposed relative to the plunger (204, 304) and used for driving the plunger (204, 304) to move.

## Description

### Field of the Invention

The present invention relates to a liquid supply device and a liquid cooling system, particularly a liquid supply device capable of supplying a cooling liquid to a liquid cooling system in time when the cooling liquid is insufficient.

### Background of the Invention

In general, a liquid cooling system essentially consists of a liquid cooling head, a radiator, a pump and a liquid storage box connected through a plurality of tubes. When the liquid cooling system is dissipating heat from an electronic component, the pump transports a cooling liquid to the liquid cooling head, the cooling liquid absorbs the heat generated by the electronic component, and then the radiator cools the cooling liquid. After the liquid cooling system is used for a long time, the cooling liquid will reduce due to vaporization, such that the cooling liquid may be insufficient. If the user does not supply the cooling liquid in time, the liquid cooling system may be damaged due to insufficient cooling liquid.

### Summary of the Invention

The present invention aims at providing a liquid supply device and a liquid cooling system equipped with the liquid supply device, thereby resolving the aforesaid problems.

This is achieved by a liquid supply device according to claim 1 and a liquid cooling system according to claim 12. The dependent claims pertain to corresponding further developments and improvements.

As will be seen more clearly from the detailed description following below, the claimed liquid supply device includes a casing, a cover, a plunger and a driving unit. The casing has a liquid outlet. The cover is connected to the casing. A chamber is formed between the casing and the cover. The chamber communicates with the liquid outlet. The plunger is movably disposed in the chamber. The driving unit is disposed relative to the plunger and used for driving the plunger to move.

As will be seen more clearly from the detailed description following below, the claimed liquid cooling system includes a liquid cooling head, a radiator, a plurality of tubes and a liquid supply device. The tubes are connected between the liquid cooling head and the radiator. The liquid supply device is selectively connected to one of the liquid cooling head, the radiator and the tubes. The liquid supply device includes a casing, a cover, a plunger and a driving unit. The casing has a liquid outlet. The cover is connected to the casing. A chamber is formed between the casing and the cover. The chamber communicates with the liquid outlet. The plunger is movably disposed in the chamber. The driving unit is disposed relative to the plunger and used for driving the plunger to move.

### Brief Description of the Drawings

In the following, the invention is further illustrated by way of example, taking reference to the accompanying drawings thereof:
FIG. 1 is a schematic view illustrating a liquid cooling system according to an embodiment of the invention,
FIG. 2 is a schematic view illustrating a liquid cooling system according to another embodiment of the invention,
FIG. 3 is a schematic view illustrating a liquid supply device according to an embodiment of the invention,
FIG. 4 is an exploded view illustrating the liquid supply device shown in FIG. 3,
FIG. 5 is an exploded view illustrating the liquid supply device shown in FIG. 3 from another viewing angle,
FIG. 6 is a cross-sectional view illustrating the liquid supply device shown in FIG. 3 along line X-X,
FIG. 7 is a cross-sectional view illustrating a liquid supply device according to another embodiment of the invention,
FIG. 8 is a cross-sectional view illustrating a liquid supply device according to another embodiment of the invention, and
FIG. 9 is a cross-sectional view illustrating a liquid supply device according to another embodiment of the invention.

### Detailed Description

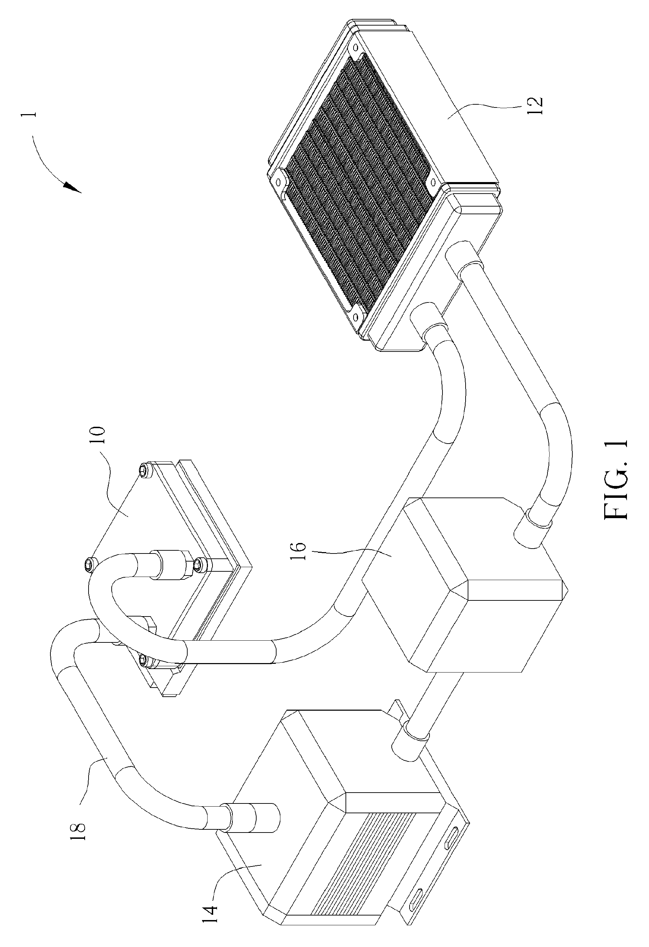

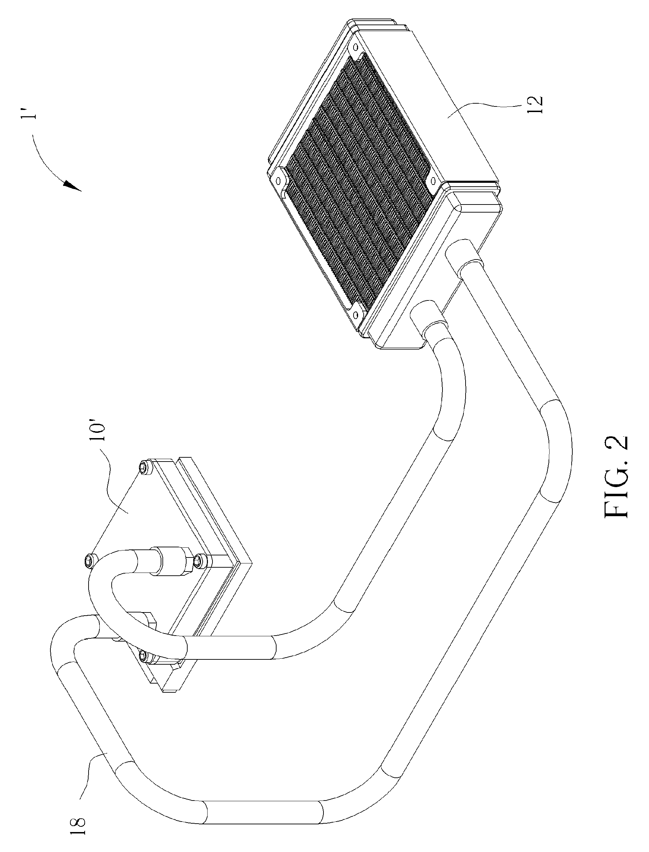

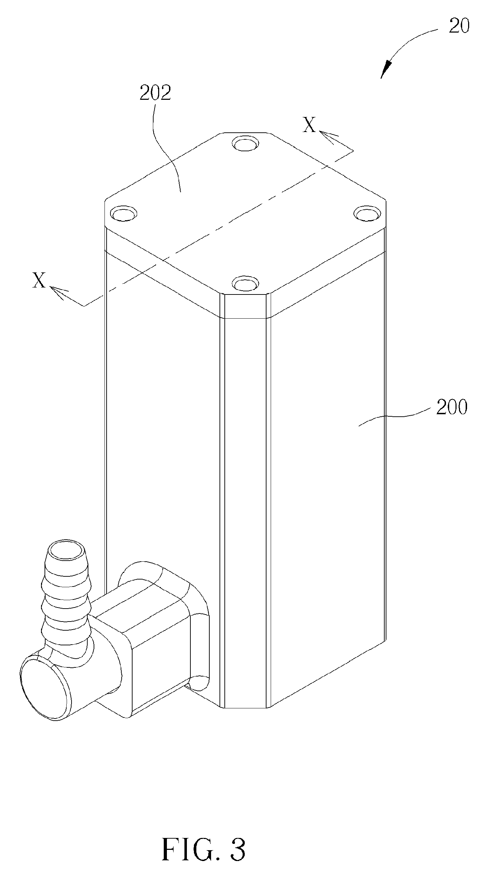

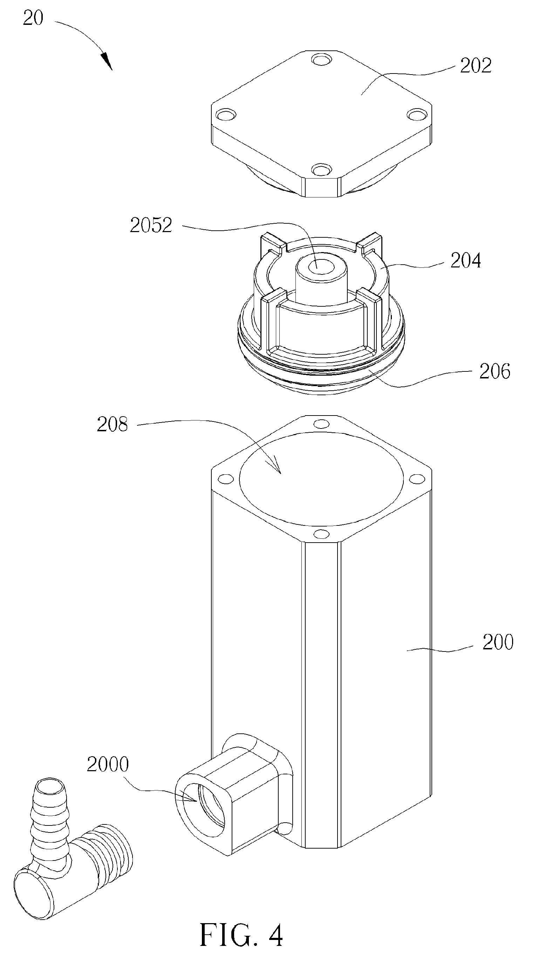

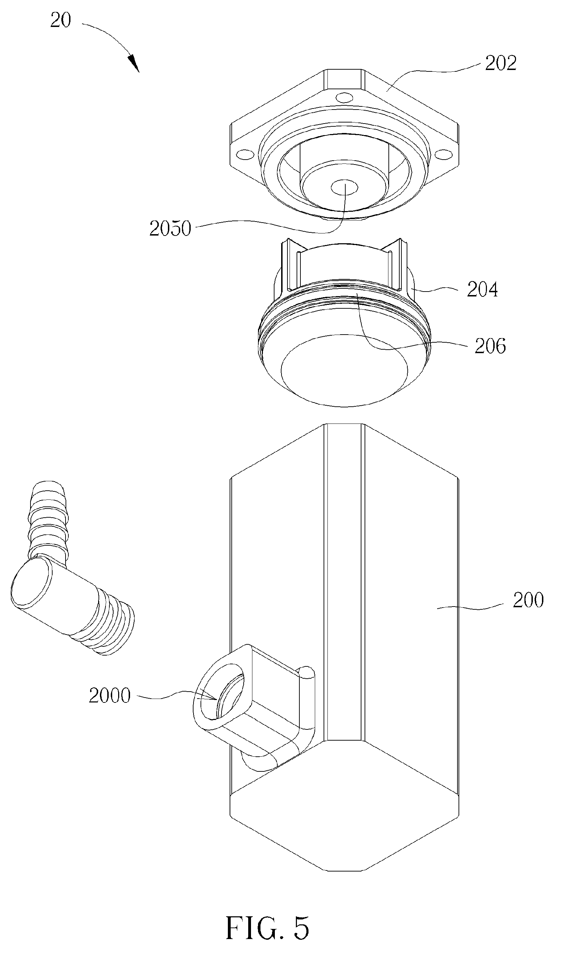

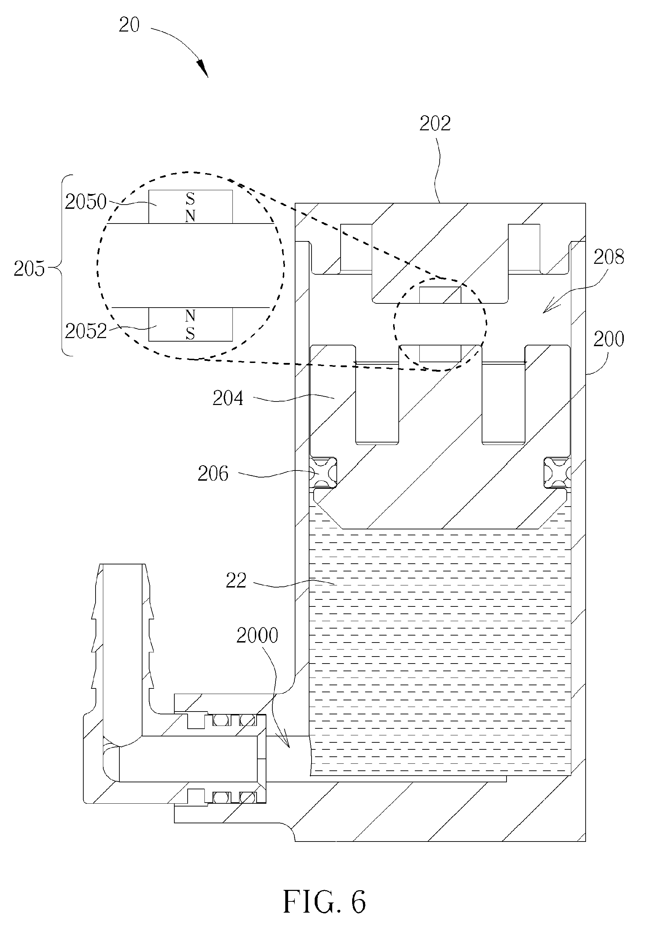

Referring to FIGs. 1 to 6, FIG. 1 is a schematic view illustrating a liquid cooling system 1 according to an embodiment of the invention, FIG. 2 is a schematic view illustrating a liquid cooling system 1' according to another embodiment of the invention, FIG. 3 is a schematic view illustrating a liquid supply device 20 according to an embodiment of the invention, FIG. 4 is an exploded view illustrating the liquid supply device 20 shown in FIG. 3, FIG. 5 is an exploded view illustrating the liquid supply device 20 shown in FIG. 3 from another viewing angle, and FIG. 6 is a cross-sectional view illustrating the liquid supply device 20 shown in FIG. 3 along line X-X.

As shown in FIG. 1, the liquid cooling system 1 includes a liquid cooling head 10, a radiator 12, a pump 14, a liquid storage box 16 and a plurality of tubes 18. The tubes 18 are connected among the liquid cooling head 10, the radiator 12, the pump 14 and the liquid storage box 16 and used for transporting a cooling liquid among the liquid cooling head 10, the radiator 12, the pump 14 and the liquid storage box 16. The cooling liquid (not shown in FIG. 1) is filled in the liquid cooling head 10, the radiator 12, the pump 14, the liquid storage box 16 and the tubes 18. When the liquid cooling system 1 of the invention is used for dissipating heat from an electronic component (not shown), the liquid cooling head 10 of the liquid cooling system 1 is attached on the electronic component. The pump 14 transports the cooling liquid to the liquid cooling head 10, the cooling liquid absorbs the heat generated by the electronic component, and then the radiator 12 cools the cooling liquid.

Compared to the liquid cooling system 1 shown in FIG. 1, the liquid cooling system 1' shown in FIG. 2 includes a liquid cooling head 10', a radiator 12 and a plurality of tubes 18. In the liquid cooling system 1', the liquid cooling head 10' may function as a pump. In other words, the pump 14 of the liquid cooling system 1 may be integrated into the liquid cooling head 10' of the liquid cooling system 1'. Furthermore, in the liquid cooling system 1', the liquid storage box 16 of the liquid cooling system 1 is omitted. In other embodiments, the liquid storage box 16 can be integrated with the radiator 12 or the liquid cooling head 10'. In other words, the liquid cooling system of the invention may be equipped with or not equipped with the liquid storage box 16 according to practical applications. In the liquid cooling system 1', the tubes 18 are connected between the liquid cooling head 10' with a pump function and the radiator 12 and used for transporting a cooling liquid between the liquid cooling head 10' and the radiator 12. The cooling liquid (not shown in FIG. 1) is filled in the liquid cooling head 10', the radiator 12 and the tubes 18. When the liquid cooling system 1' of the invention is used for dissipating heat from an electronic component (not shown), the liquid cooling head 10' of the liquid cooling system 1' is attached on the electronic component. The cooling liquid of the liquid cooling head 10' absorbs the heat generated by the electronic component and then the radiator 12 cools the cooling liquid.

As shown in FIGs. 3 to 6, the aforesaid liquid cooling system 1 or liquid cooling system 1' further includes a liquid supply device 20, wherein the liquid supply device 20 may be selectively connected to one of the liquid cooling head 10, the radiator 12, the pump 14, the liquid storage box 16 and the tubes 18 shown in FIG. 1 or selectively connected to one of the liquid cooling head 10', the radiator 12 and the tubes 18 shown in FIG. 2 according to practical applications. In the liquid cooling system 1', the liquid supply device 20 may have the function of the liquid storage box.

The liquid supply device 20 includes a casing 200, a cover 202, a plunger 204, a driving unit 205 and a washer 206. The casing 200 has a liquid outlet 2000. The cover 202 is connected to the casing 200 and a chamber 208 is formed between the casing 200 and the cover 202. The chamber 208 communicates with the liquid outlet 2000 and contains a cooling liquid 22. In practical applications, the cooling liquid 22 may be water or other liquids. The plunger 204 is movably disposed in the chamber 208. The washer 206 is sleeved on an outer wall of the plunger 204 and abuts against an inner wall of the casing 200. Accordingly, the washer 206 can prevent the cooling liquid 22 from entering a space between the cover 202 and the plunger 204.

When the liquid supply device 20 is connected to one of the liquid cooling head 10, the radiator 12, the pump 14, the liquid storage box 16 and the tubes 18 shown in FIG. 1 or connected to one of the liquid cooling head 10', the radiator 12 and the tubes 18 shown in FIG. 2, the liquid outlet 2000 communicates with one of the liquid cooling head 10, 10', the radiator 12, the pump 14, the liquid storage box 16 and the tubes 18, such that the cooling liquid 22 of the chamber 208 can be injected into one of the liquid cooling head 10, 10', the radiator 12, the pump 14, the liquid storage box 16 and the tubes 18 through the liquid outlet 2000.

The driving unit 205 is disposed relative to the plunger 204 and used for driving the plunger 204 to move. In this embodiment, the driving unit 205 includes a first magnetic area 2050 and a second magnetic area 2052, wherein the first magnetic area 2050 is disposed on the cover 202, the second magnetic area 2052 is disposed on the plunger 204, and a position of the first magnetic area 2050 is corresponding to a position of the second magnetic area 2052. As shown in FIG. 6, a magnetic pole of an end of the first magnetic area 2050 facing the second magnetic area 2052 is identical to a magnetic pole of an end of the second magnetic area 2052 facing the first magnetic area 2050, such that a magnetic repulsive force is generated between the first magnetic area 2050 and the second magnetic area 2052. It should be noted that the magnetic pole of an end of the first magnetic area 2050 facing the second magnetic area 2052 and the magnetic pole of an end of the second magnetic area 2052 facing the first magnetic area 2050 both may be north magnetic poles or south magnetic poles according to practical applications. In this embodiment, the first magnetic area 2050 may be a magnet or an electromagnet, and the second magnetic area 2052 may be a magnet.

When the liquid supply device 20 is assembled completely and the chamber 208 contains the cooling liquid 22, the magnetic repulsive force generated between the first magnetic area 2050 and the second magnetic area 2052 balances with the hydraulic pressure generated by the cooling liquid 22. At this time, the plunger 204 stays static in the chamber 208. When the cooling liquid of the liquid cooling system 1,1' reduces and then the hydraulic pressure reduces, the magnetic repulsive force generated between the first magnetic area 2050 and the second magnetic area 2052 will push the plunger 204 to move, so as to inject the cooling liquid 22 from the chamber 208 into one of the liquid cooling head 10, 10', the radiator 12, the pump 14, the liquid storage box 16 and the tubes 18. In other words, the liquid supply device 20 of the invention can supply the cooling liquid to the liquid cooling system 1,1' automatically when the cooling liquid is insufficient, so as to prevent the liquid cooling system 1, 1' from being damaged due to insufficient cooling liquid. When the magnetic repulsive force generated between the first magnetic area 2050 and the second magnetic area 2052 balances with the hydraulic pressure generated by the cooling liquid 22 again, the plunger 204 stops moving.

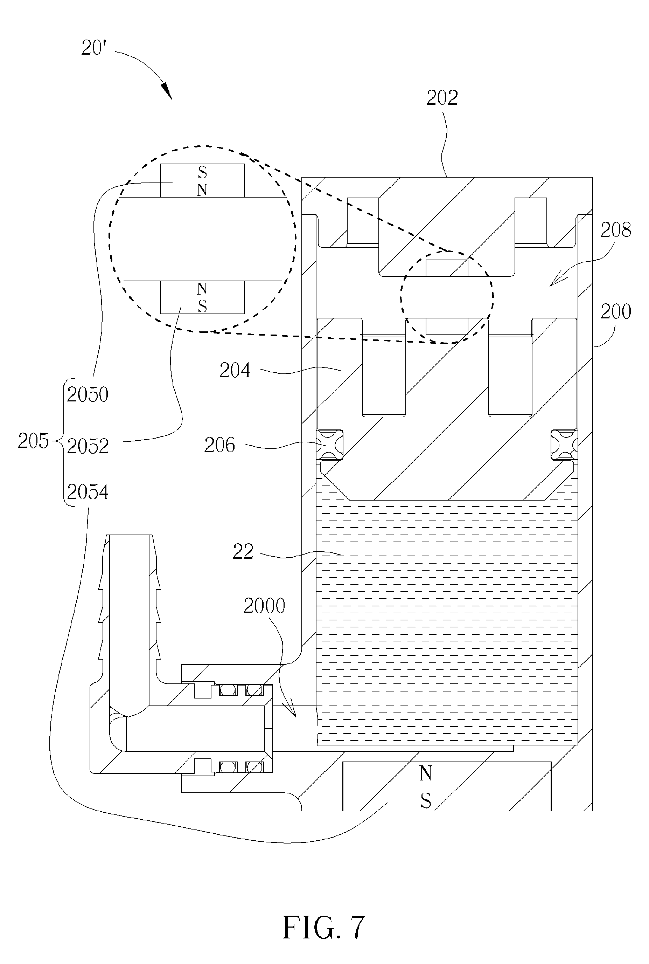

Referring to FIG. 7, FIG. 7 is a cross-sectional view illustrating a liquid supply device 20' according to another embodiment of the invention. The difference between the liquid supply device 20' and the aforesaid liquid supply device 20 is that the driving unit 205 of the liquid supply device 20' further includes a third magnetic area 2054 and the third magnetic area 2054 is disposed on the casing 200, wherein the second magnetic area 2052 is located between the first magnetic area 2050 and the third magnetic area 2054. As shown in FIG. 7, a magnetic pole of an end of the second magnetic area 2052 facing the third magnetic area 2054 is opposite to a magnetic pole of an end of the third magnetic area 2054 facing the second magnetic area 2052, such that a magnetic attraction force is generated between the second magnetic area 2052 and the third magnetic area 2054. It should be noted that the magnetic pole of an end of the second magnetic area 2052 facing the third magnetic area 2054 may be a north magnetic pole or a south magnetic pole, and the magnetic pole of an end of the third magnetic area 2054 facing the second magnetic area 2052 may be a south magnetic pole or a north magnetic pole correspondingly according to practical applications. In this embodiment, the third magnetic area 2054 may be a magnetic induction material (e.g. iron or other metals), a magnet or an electromagnet. It should be noted that the same elements in FIG. 7 and FIG. 6 are represented by the same numerals, so the repeated explanation will not be depicted herein again.

When the liquid supply device 20' is assembled completely and the chamber 208 contains the cooling liquid 22, the magnetic repulsive force generated between the first magnetic area 2050 and the second magnetic area 2052 and the magnetic attraction force generated between the second magnetic area 2052 and the third magnetic area 2054 balance with the hydraulic pressure generated by the cooling liquid 22. At this time, the plunger 204 stays static in the chamber 208. When the cooling liquid of the liquid cooling system 1,1' reduces and then the hydraulic pressure reduces, the magnetic repulsive force generated between the first magnetic area 2050 and the second magnetic area 2052 will push the plunger 204 to move and the magnetic attraction force generated between the second magnetic area 2052 and the third magnetic area 2054 will pull the plunger 204 to move, so as to inject the cooling liquid 22 from the chamber 208 into one of the liquid cooling head 10, 10', the radiator 12, the pump 14, the liquid storage box 16 and the tubes 18. When the magnetic repulsive force generated between the first magnetic area 2050 and the second magnetic area 2052 and the magnetic attraction force generated between the second magnetic area 2052 and the third magnetic area 2054 balance with the hydraulic pressure generated by the cooling liquid 22 again, the plunger 204 stops moving.

In this embodiment, the third magnetic area 2054 may be detachably disposed on a bottom of the casing 200. When a user wants to supply the cooling liquid 22 to the liquid supply device 20', the user may detach the third magnetic area 2054 from the bottom of the casing 200 first, so as to prevent the magnetic attraction force generated between the second magnetic area 2052 and the third magnetic area 2054 from hindering the supply of the cooling liquid 22.

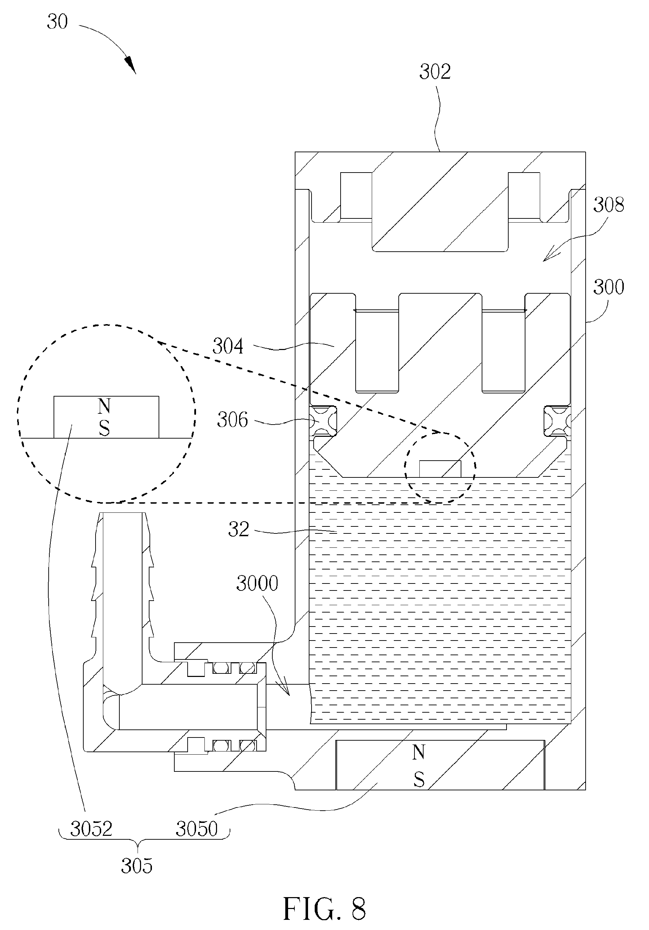

Referring to FIG. 8, FIG. 8 is a cross-sectional view illustrating a liquid supply device 30 according to another embodiment of the invention. As shown in FIG. 8, the liquid supply device 30 includes a casing 300, a cover 302, a plunger 304, a driving unit 305 and a washer 306. The casing 300 has a liquid outlet 3000. The cover 302 is connected to the casing 300 and a chamber 308 is formed between the casing 300 and the cover 302. The chamber 308 communicates with the liquid outlet 3000 and contains a cooling liquid 32. In practical applications, the cooling liquid 32 may be water or other liquids. The plunger 304 is movably disposed in the chamber 308. The washer 306 is sleeved on an outer wall of the plunger 304 and abuts against an inner wall of the casing 300. Accordingly, the washer 306 can prevent the cooling liquid 32 from entering a space between the cover 302 and the plunger 304.

When the liquid supply device 30 is connected to one of the liquid cooling head 10, the radiator 12, the pump 14, the liquid storage box 16 and the tubes 18 shown in FIG. 1 or connected to one of the liquid cooling head 10', the radiator 12 and the tubes 18 shown in FIG. 2, the liquid outlet 3000 communicates with one of the liquid cooling head 10, 10', the radiator 12, the pump 14, the liquid storage box 16 and the tubes 18, such that the cooling liquid 32 of the chamber 308 can be injected into one of the liquid cooling head 10, 10', the radiator 12, the pump 14, the liquid storage box 16 and the tubes 18 through the liquid outlet 3000.

The driving unit 305 is disposed relative to the plunger 304 and used for driving the plunger 304 to move. In this embodiment, the driving unit 305 includes a first magnetic area 3050 and a second magnetic area 3052, wherein the first magnetic area 3050 is disposed on the casing 300, the second magnetic area 3052 is disposed on the plunger 304, and a position of the first magnetic area 3050 is corresponding to a position of the second magnetic area 3052. As shown in FIG. 8, a magnetic pole of an end of the first magnetic area 3050 facing the second magnetic area 3052 is opposite to a magnetic pole of an end of the second magnetic area 3052 facing the first magnetic area 3050, such that a magnetic attraction force is generated between the first magnetic area 3050 and the second magnetic area 3052. It should be noted that the magnetic pole of an end of the first magnetic area 3050 facing the second magnetic area 3052 may be a north magnetic pole or a south magnetic pole, and the magnetic pole of an end of the second magnetic area 3052 facing the first magnetic area 3050 may be a south magnetic pole or a north magnetic pole correspondingly according to practical applications. In this embodiment, the first magnetic area 3050 may be a magnetic induction material (e.g. iron or other metals), a magnet or an electromagnet, and the second magnetic area 3052 may be a magnet.

When the liquid supply device 30 is assembled completely and the chamber 308 contains the cooling liquid 32, the magnetic attraction force generated between the first magnetic area 3050 and the second magnetic area 3052 balances with the hydraulic pressure generated by the cooling liquid 32. At this time, the plunger 304 stays static in the chamber 308. When the cooling liquid of the liquid cooling system 1,1' reduces and then the hydraulic pressure reduces, the magnetic attraction force generated between the first magnetic area 3050 and the second magnetic area 3052 will pull the plunger 304 to move, so as to inject the cooling liquid 32 from the chamber 308 into one of the liquid cooling head 10, 10', the radiator 12, the pump 14, the liquid storage box 16 and the tubes 18. In other words, the liquid supply device 30 of the invention can supply the cooling liquid to the liquid cooling system 1,1' automatically when the cooling liquid is insufficient, so as to prevent the liquid cooling system 1, 1' from being damaged due to insufficient cooling liquid. When the magnetic attraction force generated between the first magnetic area 3050 and the second magnetic area 3052 balances with the hydraulic pressure generated by the cooling liquid 32 again, the plunger 304 stops moving.

In this embodiment, the first magnetic area 3050 may be detachably disposed on a bottom of the casing 300. When a user wants to supply the cooling liquid 32 to the liquid supply device 30, the user may detach the first magnetic area 3050 from the bottom of the casing 300 first, so as to prevent the magnetic attraction force generated between the first magnetic area 3050 and the second magnetic area 3052 from hindering the supply of the cooling liquid 32.

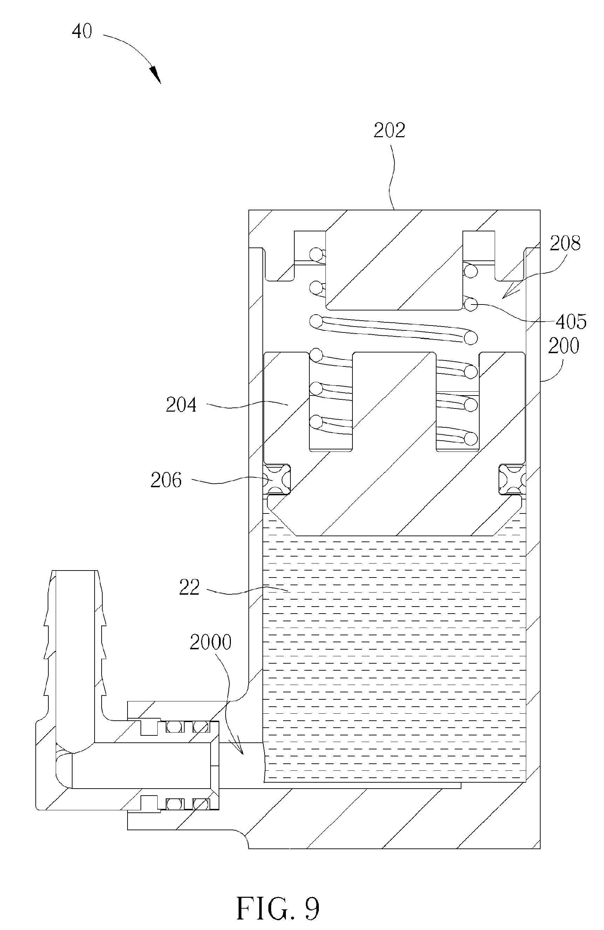

Referring to FIG. 9, FIG. 9 is a cross-sectional view illustrating a liquid supply device 40 according to another embodiment of the invention. The difference between the liquid supply device 40 and the aforesaid liquid supply device 20 is that the liquid supply device 40 replaces the aforesaid driving unit 205 by a driving unit 405. As shown in FIG. 9, the driving unit 405 may be a resilient member (e.g. spring or other resilient objects) and opposite ends of the driving unit 405 abut against the cover 202 and the plunger 204, respectively. When the liquid supply device 40 is connected to one of the liquid cooling head 10, the radiator 12, the pump 14, the liquid storage box 16 and the tubes 18 shown in FIG. 1 or connected to one of the liquid cooling head 10', the radiator 12 and the tubes 18 shown in FIG. 2, the liquid outlet 2000 communicates with one of the liquid cooling head 10, 10', the radiator 12, the pump 14, the liquid storage box 16 and the tubes 18, such that the cooling liquid 22 of the chamber 208 can be injected into one of the liquid cooling head 10, 10', the radiator 12, the pump 14, the liquid storage box 16 and the tubes 18 through the liquid outlet 2000. It should be noted that the same elements in FIG. 9 and FIG. 6 are represented by the same numerals, so the repeated explanation will not be depicted herein again.

When the liquid supply device 40 is assembled completely and the chamber 208 contains the cooling liquid 22, the driving unit 405 is compressed. At this time, the driving unit 405 pushes the plunger 204 to move downward in the chamber 208 till the hydraulic pressure of the liquid cooling system 1,1' balances. When the cooling liquid of the liquid cooling system 1,1' reduces and then the hydraulic pressure reduces, the driving unit 405 of the liquid supply device 40 will push the plunger 204 to move, so as to inject the cooling liquid 22 from the chamber 208 into one of the liquid cooling head 10, 10', the radiator 12, the pump 14, the liquid storage box 16 and the tubes 18. In other words, the liquid supply device 40 of the invention can supply the cooling liquid to the liquid cooling system 1,1' automatically when the cooling liquid is insufficient, so as to prevent the liquid cooling system 1, 1' from being damaged due to insufficient cooling liquid. It should be noted that in addition to using the driving unit 405 to generate elastic force to push the plunger 204 to move, the invention may also replace the driving unit 405 by other mechanisms, which may generate normal force, shearing force, torque or magnetic force, to push the plunger 204 to move, so as to supply the cooling liquid.

As mentioned in the above, the liquid supply device of the invention is selectively connected to one of the liquid cooling head, the radiator, the pump, the liquid storage box and the tubes. When the cooling liquid reduces and then the hydraulic pressure of the liquid cooling system reduces, the liquid supply device utilizes the driving unit to drive the plunger to move, so as to inject the cooling liquid from the chamber into the liquid cooling system. In other words, the liquid supply device of the invention can supply the cooling liquid to the liquid cooling system automatically when the cooling liquid is insufficient, so as to prevent the liquid cooling system from being damaged due to insufficient cooling liquid.

## Claims

1. A liquid supply device (20, 20', 30, 40) **characterized by** the liquid supply device (20, 20', 20", 30, 40) comprising:
a casing (200, 300) having a liquid outlet (2000, 3000);
a cover (202, 302) connected to the casing (200, 300), a chamber (208, 308) being formed between the casing (200, 300) and the cover (202, 302), the chamber (208, 308) communicating with the liquid outlet (2000, 3000);
a plunger (204, 304) movably disposed in the chamber (208, 308); and
a driving unit (205, 305, 405) disposed relative to the plunger (204, 304)
and used for driving the plunger (204, 304) to move.

2. The liquid supply device (20, 20') of claim 1 further **characterized in that** the driving unit (205) comprises a first magnetic area (2050) and a second magnetic area (2052), the first magnetic area (2050) is disposed on the cover (202), the second magnetic area (2052) is disposed on the plunger (204), a position of the first magnetic area (2050) is corresponding to a position of the second magnetic area (2052), a magnetic pole of an end of the first magnetic area (2050) facing the second magnetic area (2052) is identical to a magnetic pole of an end of the second magnetic area (2052) facing the first magnetic area (2050), such that a magnetic repulsive force is generated between the first magnetic area (2050) and the second magnetic area (2052).

3. The liquid supply device (20, 20') of claim 2 further **characterized in that** the first magnetic area (2050) is a magnet or an electromagnet, and the second magnetic area (2052) is a magnet.

4. The liquid supply device (20') of claim 2 further **characterized in that** the driving unit (205) further comprises a third magnetic area (2054), the third magnetic area (2054) is disposed on the casing (200), the second magnetic area (2052) is located between the first magnetic area (2050) and the third magnetic area (2054), a magnetic pole of an end of the second magnetic area (2052) facing the third magnetic area (2054) is opposite to a magnetic pole of an end of the third magnetic area (2054) facing the second magnetic area (2052), such that a magnetic attraction force is generated between the second magnetic area (2052) and the third magnetic area (2054).

5. The liquid supply device (20') of claim 4 further **characterized in that** the third magnetic area (2054) is a magnetic induction material, a magnet or an electromagnet.

6. The liquid supply device (20') of claim 4 further **characterized in that** the third magnetic area (2054) is detachably disposed on a bottom of the casing (200).

7. The liquid supply device (30) of claim 1 further **characterized in that** the driving unit (305) comprises a first magnetic area (3050) and a second magnetic area (3052), the first magnetic area (3050) is disposed on the casing (300), the second magnetic area (3052) is disposed on the plunger (304), a position of the first magnetic area (3050) is corresponding to a position of the second magnetic area (3052), a magnetic pole of an end of the first magnetic area (3050) facing the second magnetic area (3052) is opposite to a magnetic pole of an end of the second magnetic area (3052) facing the first magnetic area (3050), such that a magnetic attraction force is generated between the first magnetic area (3050) and the second magnetic area (3052).

8. The liquid supply device (30) of claim 7 further **characterized in that** the first magnetic area (3050) is a magnetic induction material, a magnet or an electromagnet, and the second magnetic area (3052) is a magnet.

9. The liquid supply device (30) of claim 7 further **characterized in that** the first magnetic area (3050) is detachably disposed on a bottom of the casing (300).

10. The liquid supply device (40) of claim 1 further **characterized in that** the driving unit (405) is a resilient member and opposite ends of the driving unit (405) abut against the cover (202) and the plunger (204), respectively.

11. The liquid supply device (20, 20', 30, 40) of claim 1 further **characterized in that** the liquid supply device (20, 20', 30, 40) further comprises a washer (206, 306) sleeved on an outer wall of the plunger (204, 304) and abutting against an inner wall of the casing (200, 300).

12. A liquid cooling system (1, 1') **characterized by** the liquid cooling system (1, 1') comprising:
a liquid cooling head (10, 10');
a radiator (12);
a plurality of tubes (18) connected between the liquid cooling head (10,
10') and the radiator (12); and
a liquid supply device (20, 20', 30, 40) of one of claims 1 to 11 selectively
connected to one of the liquid cooling head (10, 10'), the radiator (12)
and the tubes (18).

13. The liquid cooling system (1) of claim 12 further **characterized in that** the liquid cooling system (1) further comprises a pump (14), the tubes (18) are connected between the liquid cooling head (10), the radiator (12) and the pump (14), the liquid supply device (20, 20', 30, 40) is selectively connected to one of the liquid cooling head (10), the radiator (12), the pump (14) and the tubes (18).

14. The liquid cooling system (1) of claim 12 further **characterized in that** the liquid cooling system (1) further comprises a liquid storage box (16), the tubes (18) are connected between the liquid cooling head (10), the radiator (12) and the liquid storage box (16), the liquid supply device (20, 20', 30, 40) is selectively connected to one of the liquid cooling head (10), the radiator (12), the liquid storage box (16) and the tubes (18).
